# FASCICULE DE BREVET EUROPEEN

(11) **EP 1 229 587 B1**
(45) Date de publication et mention de la délivrance du brevet: **11.08.2004**
(21) Numéro de dépôt: 02354022.2
(22) Date de dépôt: 04.02.2002
(51) Int. Cl.: H01L 29/06, H01L 27/02

(54) **Structure de protection contre des parasites**
Schutzstruktur gegen Störungen
Protection structure against parasites

(30) Priorité: 05.02.2001 FR 0101525
(43) Date de publication de la demande: 07.08.2002
(73) Titulaire: STMicroelectronics S.A., 92120 Montrouge (FR)
(72) Inventeur: Belot, Didier, 38140 Rives (FR)
(74) Mandataire: de Beaumont, Michel

(56) Documents cités:
- EP-A- 0 081 396
- FR-A- 2 787 636
- US-A- 5 821 148

## Description

La présente invention concerne des circuits intégrés destinés à fonctionner à très haute fréquence et plus particulièrement de tels circuits dont certaines parties sont sensibles à des signaux parasites. Par exemple, dans le domaine des télécommunications et des téléphones portables, on souhaite intégrer sur une même puce des circuits logiques de traitement de signal et des circuits analogiques d'amplification, destinés à fonctionner à des fréquences très élevées, supérieures à 1 GHz, comprises par exemple dans la plage de 2 à 10 GHz. En particulier, il est généralement prévu un amplificateur analogique à faible bruit directement connecté à la sortie de l'antenne. Il importe d'éviter que le bruit résultant des commutations des signaux numériques affecte les entrées de l'amplificateur car alors ce bruit serait réinjecté dans le circuit avec un très fort gain.

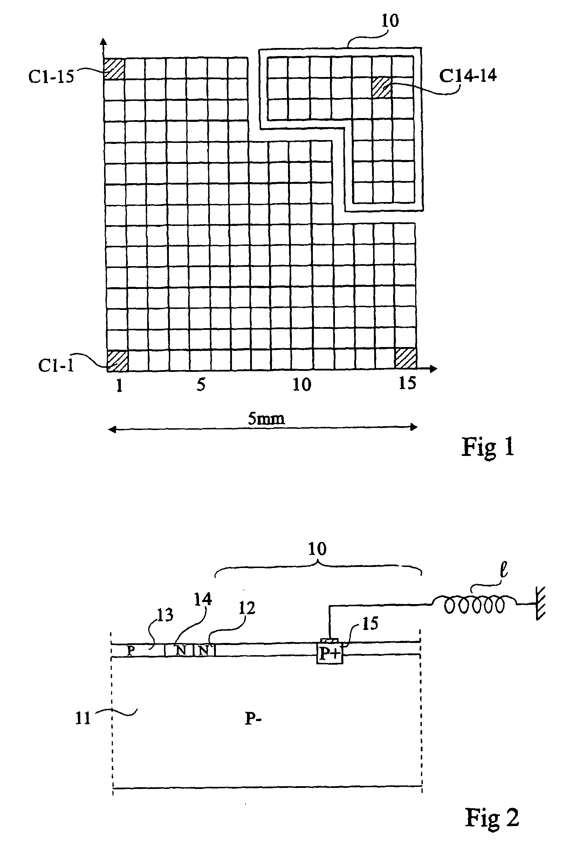

Pour tester la sensibilité au bruit d'un circuit intégré et de divers systèmes de protection, on peut utiliser une structure de test telle que celle représentée en figure 1. Dans cette structure de test, la puce est divisée en cases carrées. Par exemple, une partie de puce de 5 millimètres de côté est divisée en 15 X 15 cases. On forme un circuit susceptible d'émettre des signaux en créneaux dans la première case (case C1-1 de la première colonne et de la première rangée) et on étudie le signal haute fréquence recueilli dans les autres cases. Une partie du composant comprenant les cases les plus éloignées diagonalement de la case C1-1 est entourée d'une structure de protection 10. On teste la qualité de cette structure de protection en comparant le bruit recueilli dans la case C14-14 (quatorzième colonne, quatorzième rangée) disposée à l'intérieur de la structure de protection et le bruit recueilli par exemple dans la case C1-15 (première colonne, quinzième rangée) située sensiblement à la même distance de la case C1-1 que les cases disposées à l'intérieur de la structure de protection 10.

Comme l'illustre la vue en coupe partielle de la figure 2, on s'intéressera plus particulièrement au cas où la structure est formée sur un substrat de silicium monocristallin massif 11 faiblement dopé de type P (P⁻). On suppose que les divers composants du circuit intégré sont formés dans une partie supérieure de ce substrat, par exemple dans une couche épitaxiée faiblement dopée de type N dont une partie 12 est représentée à la limite de la structure de protection 10. Les divers composants sont par exemple formés directement dans cette couche épitaxiée (cas de certains transistors bipolaires) ou dans des caissons plus fortement dopés de type P (13) ou de type N (14) dans lesquels on trouvera notamment des transistors MOS à canal N et à canal P. La structure de protection est constituée d'un mur 15 fortement dopé de type P et relié à la masse.

Une telle structure de protection, décrite par exemple dans FR-A-2787636, s'avère efficace aux fréquences inférieures à 1 GHz. Toutefois, comme l'illustre la figure 3, la protection devient inefficace quand les fréquences augmentent. Ceci est dû en particulier au fait que la connexion entre le mur 15 fortement dopé et la masse comprend inévitablement une inductance l dont l'impédance augmente avec la fréquence.

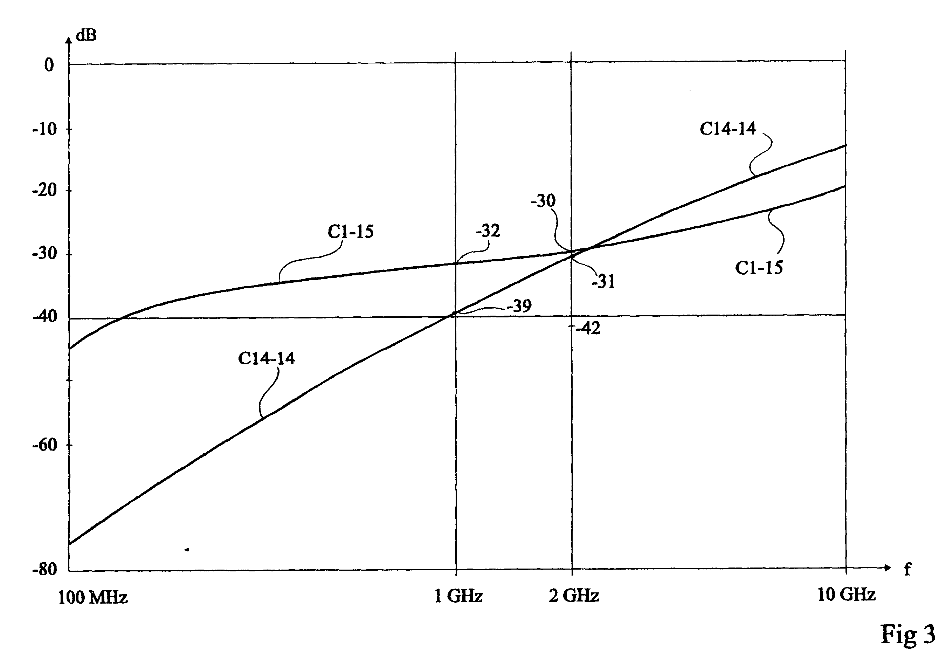

La figure 3 représente l'atténuation en dB au niveau de la case C1-15 et au niveau de la case C14-14 d'un signal émis par la case C1-1, en fonction de la fréquence (en échelle logarithmique) entre 100 MHz et 10 GHz. Dans la case C1-15, on voit que cette atténuation diminue quand la fréquence augmente. Dans la case C14-14 (ou dans toute autre case située à l'intérieur de la structure de protection 10) on voit que, jusqu'à une fréquence de l'ordre du gigahertz, l'atténuation est nettement plus importante que pour la case C1-15. Toutefois, pour des fréquences de l'ordre de 1 à 2 GHz, la pente de la courbe C14-14 change et l'atténuation procurée par le mur d'isolement 15 devient négligeable. On constate même que, pour des fréquences supérieures à 2 GHz, le mur d'isolement a un effet négatif, à savoir que l'atténuation du signal en provenance de la case C1-1 est moins importante dans la case C14-14 "protégée" par la structure d'isolement 10 que dans la case C1-15 qui elle n'est pas protégée.

On pourrait trouver diverses explications théoriques à ce phénomène qui en tout cas est certainement lié au fait que l'impédance de la connexion du mur d'isolement 15 à la masse devient élevée. Ainsi, dans l'art antérieur, on a essayé divers moyens pour réduire la valeur de cette impédance. L'un de ces moyens est d'utiliser un mode de montage des puces semiconductrices dit "flip chip" dans lequel les points de connexion sur la puce sont métallisés et revêtus de billes conductrices. Chaque bille conductrice est ensuite directement mise au contact d'une plage métallisée d'une carte de circuit imprimé à laquelle cette puce doit être connectée. On obtient ainsi des connexions à impédance beaucoup plus faible que dans le cas où les puces sont montées dans un boîtier et reliées aux pattes du boîtier par des fils. Toutefois, ceci n'a pas permis de résoudre complètement le problème posé et n'a amélioré que partiellement les caractéristiques des structures de protection connues.

Ainsi un objet de la présente invention est de prévoir une nouvelle structure de protection contre des parasites d'une zone d'un circuit intégré formé sur un substrat massif.

Pour atteindre cet objet, la présente invention prévoit une structure de protection d'une zone d'un circuit integré formé dans la partie superieure d'une première zone d'une tranche semiconductrice comprenant un substrat massif faiblement dopé d'un premier type de conductivité contre des parasites haute fréquence susceptibles d'être injectés à partir de composants formés dans la partie supérieure d'une deuxième zone de la tranche, comprenant un mur très fortement dopé du premier type de conductivité ayant sensiblement la profondeur de ladite partie supérieure, ledit mur étant divisé en segments dont chacun est connecté à un plan de masse par l'intermédiaire d'un montage de type flip chip. Selon un mode de réalisation de la présente invention, le premier type de conductivité est le type P.

Selon un mode de réalisation de la présente invention, l'impédance entre deux segments successifs est supérieure à l'impédance de connexion à la masse de chaque segment.

Selon un mode de réalisation de la présente invention,

le mur d'isolement est entouré d'une zone moyennement dopée du premier type de conductivité.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 représente une structure de test d'un circuit intégré ;
la figure 2 représente une vue en coupe schématique et simplifiée d'une portion d'un circuit intégré au voisinage d'un mur d'isolement ;
la figure 3 représente l'atténuation en fonction de la fréquence en divers points d'une puce de circuit intégré ;
la figure 4 représente une vue de dessus partielle d'un mur d'isolement selon la présente invention ; et
la figure 5 représente une vue partielle en coupe d'un mur d'isolement selon la présente invention.

Conformément à l'usage dans le domaine de la représentation des composants semiconducteurs, les diverses vues en coupe et vues de dessus de composants ne sont pas tracées à l'échelle dans les diverses figures. Dans ces figures, de mêmes références désignent des éléments identiques ou similaires.

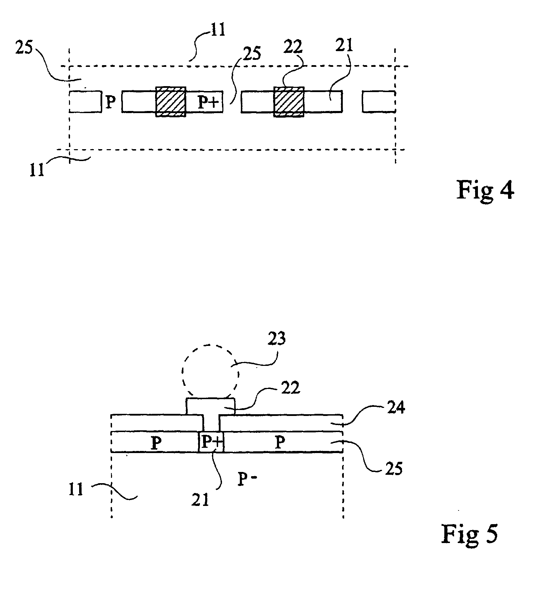

Comme l'illustrent les figures 4 et 5, le mur d'isolement selon la présente invention est divisé en segments 21 fortement dopés de type P (P⁺). Une métallisation 22 vient en contact avec chaque segment et chacune des métallisations 22 est reliée indépendamment à un plan de masse. De préférence, cette liaison est réalisée par un montage de type flip chip tel que décrit précédemment. Ainsi, comme on le voit mieux en figure 5, chaque région 21 formée dans un substrat 11 faiblement dopé de type P (P⁻) est en contact avec une métallisation 22 elle-même surmontée d'une bille de soudure 23 destinée à assurer le montage flip chip. Bien entendu cette représentation est extrêmement schématique et l'on connaît dans la technique divers moyens de préparer des connexions pour un montage flip chip. On a représenté à la surface de la tranche semiconductrice une couche isolante 24 qui est ouverte aux emplacements où la métallisation 22 vient en contact avec les segments 21.

La profondeur du mur d'isolement 21 sera celle d'une région fortement dopée de type P (P⁺) dans la technologie considérée. Sa largeur sera de préférence inférieure à la plus grande largeur d'un plot de contact 22.

De préférence, la partie supérieure du substrat 11 au voisinage de la région du mur d'isolement 21 est constituée d'une région 25 dopée de type P, à un niveau de dopage intermédiaire entre le dopage du substrat 11 et le dopage très élevé de la région 21. Cette région 25 peut par exemple s'étendre sur une distance supérieure à 100 µm de part et d'autre du mur d'isolement 21.

L'écart entre les segments 21 et le dopage de la région 25 de type P sont choisis pour que l'impédance entre deux segments soit supérieure ou égale à l'impédance de contact entre la région 21 et le plan de masse auquel elle est reliée par l'intermédiaire de la métallisation 22 et de la bille de soudure 23.

Comme le représente la figure 3, on s'aperçoit qu'avec un mur en pointillés selon la présente invention, on obtient pour une fréquence de 2 GHz, toutes choses égales d'ailleurs, un amortissement de -42 dB entre les cases C1-1 et C14-14, alors que cet amortissement était seulement de -31 dB avec un mur continu et que l'amortissement "naturel" apparaissant sur la courbe C1-15 était de l'ordre de -30 dB.

## Revendications

1. Structure de protection d'une zone d'un circuit intégré formé dans la partie supérieure d'une première zone d'une tranche semiconductrice comprenant un substrat massif (11) faiblement dopé d'un premier type de conductivité contre des parasites haute fréquence susceptibles d'être injectés à partir de composants formés dans la partie supérieure d'une deuxième zone de la tranche, comprenant un mur (21) très fortement dopé du premier type de conductivité ayant sensiblement la profondeur de ladite partie supérieure, ledit mur étant divisé en segments, **caractérisée en ce que** chaque segment dudit mur est connecté à un plan de masse par l'intermédiaire d'un montage de type flip chip.

2. Structure de protection selon la revendication 1, **caractérisée en ce que** le premier type de conductivité est le type P.

3. Structure de protection selon la revendication 1, **caractérisée en ce que** l'impédance entre deux segments successifs est supérieure à l'impédance de connexion à la masse de chaque segment.

4. Structure de protection selon la revendication 1, **caractérisée en ce que** le mur d'isolement est entouré d'une zone (25) moyennement dopée du premier type de conductivité.

## Patentansprüche

1. Eine Struktur zum Schutz eines Bereichs einer integrierten Schaltung, die in dem oberen Teil eines ersten Bereichs eines Halbleiterwafers mit einem leicht dotierten Hauptsubstrats (11) mit einem ersten Leitfähigkeitstyp ausgebildet ist, und zwar gegenüber Hochfrequenzstörungen, die dazu neigen, von Bauelementen, die in dem oberen Teil eines zweiten Bereichs des Wafers ausgebildet sind, injiziert zu werden, wobei die Struktur eine sehr stark dotierte Wand (21) des ersten Leitfähigkeitstyp mit im Wesentlichen der Tiefe des oberen Teils aufweist, wobei die Wand in zwei Segmente unterteilt ist, **dadurch gekennzeichnet, dass** jedes Segment der Wand mit einer Masseplatte bzw. Ebene verbunden ist, und zwar über eine Anordnung des Flip-Chip-Typs.

2. Schutzstruktur nach Anspruch 1, wobei der erste Leitfähigkeitstyp der P-Typ ist.

3. Schutzstruktur nach Anspruch 1, wobei die Impedanz inzwischen aufeinanderfolgenden Segmenten größer ist als die Erdungsimpedanz jedes Segments.

4. Schutzstruktur nach Anspruch 1, wobei die isolierende Wand umgeben ist mit einem mitteldotierten Bereich (25) des ersten Leitfähigkeitstyps.

## Claims

1. A structure of protection of an area of an integrated circuit formed in the upper part of a first area of a semiconductive wafer including a lightly-doped bulk substrate (11) of a first conductivity type against high-frequency noise likely to be injected from components formed in the upper portion of a second area of the wafer, including a very heavily-doped wall (21) of the first conductivity type having substantially the depth of said upper portion, said wall being divided into segments, **characterized in that** each segment of said wall is connected to a ground plane via an assembly of flip-chip type.

2. The protection structure of claim 1, wherein the first conductivity type is type P.

3. The protection structure of claim 1, wherein the impedance between two successive segments is greater than the grounding impedance of each segment.

4. The protection structure of claim 1, wherein the isolating wall is surrounded with a medium-doped area (25) of the first conductivity type.
